# EUROPEAN PATENT APPLICATION

(11) **EP 4 749 923 A1**
(43) Date of publication of application: **27.05.2026**
(21) Application number: 24215526.5
(22) Date of filing: 26.11.2024
(51) Int. Cl.: H03K 17/0412

(54) **DRIVER SYSTEM AND METHOD FOR THE DRIVER SYSTEM**

(71) Applicant: NXP USA, Inc., Austin, TX 78735 (US)
(72) Inventor: Shuvalov, Denis Sergeevich, 5656 AG Eindhoven (NL)
(74) Representative: Schmütz, Christian Klaus Johannes

(57) **Abstract**

The present disclosure relates to a driver system, the driver system comprising: a driver circuit, a compensation circuit, a first driver terminal, a second driver terminal, and a third driver terminal, wherein the driver circuit comprises a first switching transistor and a first current mirror, wherein the first current mirror comprises a first reference transistor and a first mirror transistor, wherein the first reference transistor is integrated into a first circuit branch of the driver circuit, wherein the first switching transistor and the first mirror transistor are integrated into a second circuit branch of the driver circuit, such that the first switching transistor and the first mirror transistor are connected in series, wherein the compensation circuit is coupled to the gate terminal of the first mirror transistor, and wherein a second switching transistor and a compensation capacitor are integrated in the compensation branch.

## Description

### TECHNICAL FIELD

The present disclosure relates to a driver system for driving a load branch and to a method for the driver system.

### BACKGROUND

Driver systems may be used to drive the load branch. Such load may be used for communication purpose. High frequencies may be achieved through the low rise times and the low fall times. For fast switching times, MOSFETs are often used as transistors. The generation of short control pulses, for example in the range of several nanoseconds, for driving the load branch enables high communication speeds.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Aspects of the disclosure are defined in the accompanying claims.

In accordance with a first aspect of the present disclosure, a driver system is provided. The driver system comprising: a driver circuit, a compensation circuit, a first driver terminal, a second driver terminal, and a third driver terminal, wherein the driver circuit comprises a first switching transistor and a first current mirror, wherein the first current mirror comprises a first reference transistor and a first mirror transistor, wherein the first reference transistor is integrated into a first circuit branch of the driver circuit, wherein the first circuit branch extends from the first driver terminal to the third driver terminal, wherein the first switching transistor and the first mirror transistor are integrated into a second circuit branch of the driver circuit, such that the first switching transistor and the first mirror transistor are connected in series, wherein the second circuit branch extends from the second driver terminal to the third driver terminal, wherein the compensation circuit is coupled to the gate terminal of the first mirror transistor, wherein the compensation circuit comprises a compensation branch coupled between the gate terminal of the first mirror transistor and the third driver terminal of the driver circuit, and wherein a second switching transistor and a compensation capacitor are integrated in the compensation branch.

In one or more embodiments, the first reference transistor is coupled to the first mirror transistor to control the first mirror transistor such that a second branch current through the second circuit branch is caused based on a first branch current through the first circuit branch.

In one or more embodiments, a first current source is integrated into the first circuit branch, which is configured to generate the first branch current, in particular as a predefined first branch current.

In one or more embodiments, the compensation circuit is configured to precharge the compensation capacitor.

In one or more embodiments, the driver system is configured to drive the first and second switching transistors to a closed state at a turn-on time.

In one or more embodiments, the driver system comprises a control unit configured to drive the first and second switching transistors to the closed state at the turn-on time.

In one or more embodiments, the driver system is configured to generate a first node voltage, which rises to a first reference value, at a first node (N) of the second circuit branch in response to the first switching transistor changing to the closed state, wherein the first node is arranged in the second circuit branch between the first circuit transistor and the first mirror transistor.

In one or more embodiments, the driver system is configured to generate a second node voltage, falling from a second reference value, at a second node (M) of the compensation branch in response to the second switching transistor changing to the closed state, wherein the second node is arranged in the compensation branch between the second circuit transistor and the compensation capacitor.

In one or more embodiments, the driver system is configured, in response to the second switching transistor changing to the closed state, such that the second node voltage falls from the second reference value to a fourth reference value.

In one or more embodiments, the driver system is configured, in response to the first switching transistor changing to the closed state, such that the first node voltage rises from a third reference value to the first reference value.

In one or more embodiments, the compensation capacitance of the compensation capacitor corresponds to a drain-gate capacitance of the first mirror transistor.

In one or more embodiments, the compensation capacitor is formed by a compensation transistor which drain terminal and source terminal are coupled.

In one or more embodiments, a channel width of the compensation transistor corresponds to half of a channel width of the first mirror transistor.

In one or more embodiments, a load branch is coupled either between the first driver terminal and the second driver terminal or between the second driver terminal and the third driver terminal.

In accordance with a second aspect of the present disclosure, method for a driver system is provided. The driver system comprises a driver circuit, a compensation circuit, a first driver terminal, a second driver terminal, and a third driver terminal, wherein the driver circuit comprises a first switching transistor and a first current mirror, wherein the first current mirror comprises a first reference transistor and a first mirror transistor, wherein the first reference transistor is integrated into a first circuit branch of the driver circuit, wherein the first circuit branch extends from the first driver terminal to the third driver terminal, wherein the first switching transistor and the first mirror transistor are integrated into a second circuit branch of the driver circuit, such that the first switching transistor and the first mirror transistor are connected in series, wherein the second circuit branch extends from the second driver terminal to the third driver terminal, wherein the compensation circuit is coupled to the gate terminal of the first mirror transistor, wherein the compensation circuit comprises a compensation branch coupled between the gate terminal of the first mirror transistor and the third driver terminal of the driver circuit, wherein a second switching transistor and a compensation capacitor are integrated in the compensation branch. The method comprising the steps of: a) controlling the first and second switching transistors via the driver system to switch to a closed state at a turn-on time; b) generating, in response to the first switching transistor changing to the closed state, a first node voltage rising from a third reference value to a first reference value at a first node (N) of the second circuit branch via the driver system, wherein the first node is arranged between the first switching transistor and the first mirror transistor in the second circuit branch; and c) generating, in response to the second switching transistor changing to the closed state, a second node voltage falling from a second reference value to a fourth reference value at a second node (M) of the compensation branch via the driver system, wherein the second node is arranged in the compensation branch between the second circuit transistor and the compensation capacitor.

### DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:
Figure 1 shows a simplified block diagram of an embodiment of a driver system.
Figures 2A to 2D show different waveform diagrams.
Figure 3 shows a simplified block diagram of another embodiment of a driver system.
Figures 4A to 4E show different waveform diagrams.
Figure 5 shows a simplified block diagram of another embodiment of a driver system.
Figure 6 shows an embodiment of a simplified flow chart.

### DESCRIPTION OF EMBODIMENTS

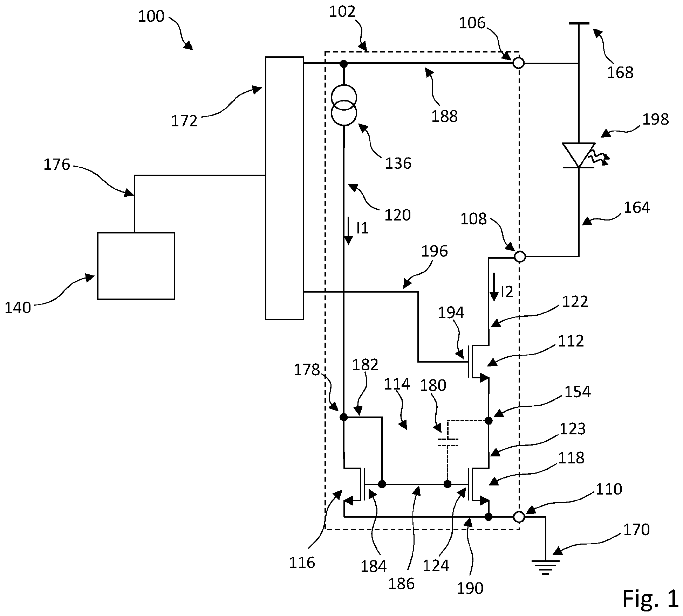

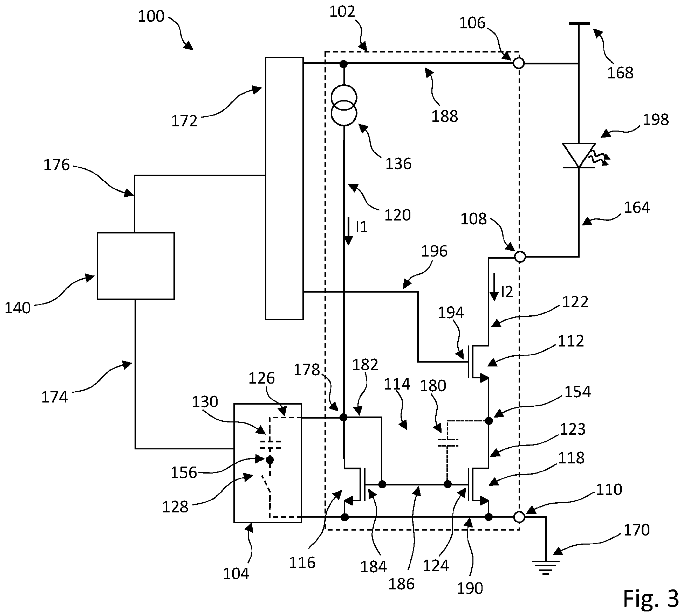

Figure 1 is a schematic illustration of an example of a driver system 100. The driver system 100 comprises a driver circuit 102. The driver system 100 may further comprise a control circuit 172 and a control unit 140. The example of the driver system 100 shown in Figure 1 does not comprise a compensation circuit. However, the following discussion of the example of the driver system 100 from Figure 1 may be helpful in understanding the further example of a driver system 100, which is schematically shown in Figure 3.

The driver system 100 comprises a plurality of terminals 106, 108, 110. The first terminal 106 is also referred to as the first driver terminal 106. The second terminal 108 is also referred to as the second driver terminal 108. The third terminal 110 is also referred to as the third driver terminal 110. The first driver terminal 106 and the third driver terminal 110 may be coupled to a voltage source such that an operating voltage falls between the first driver terminal 106 and the third driver terminal 110. The first driver terminal 106 may be coupled to a first voltage potential 168, for example, and the third driver terminal 110 may be coupled to a second voltage potential 170, in particular ground potential. The difference between the first voltage potential 168 and the second voltage potential 170 may be the operating voltage. In an example, a load branch 164 may be coupled between the first driver terminal 106 and the second driver terminal 108. At least one light-emitting diode (LED) may be integrated into the load branch 164. In another example, further loads or other loads may be integrated into the load branch.

In an example, the driver terminals 106, 108, 110 may each be formed by the driver circuit 102. As an effect, the driver circuit 102 may be supplied with the electrical operating voltage via the first driver terminal 106 and the third driver terminal 110. In an example, the driver circuit 102 may be used to drive a load, in particular at least one LED, which is integrated in the load branch 164.

The driver circuit 102 comprises a branch 120, also referred to as the first circuit branch 120. The first circuit branch 120 extends between the first driver terminal 106 and the third driver terminal 110. The driver circuit 102 comprises a further branch 122, also referred to as the second circuit branch 122. The second circuit branch 122 extends between the second driver terminal 108 and the third driver terminal 110.

The driver circuit 102 comprises a transistor 112, also referred to as a first switching transistor 112. The first switching transistor 112 may be configured as a MOSFET transistor, in particular as an N-channel MOSFET transistor.

Each transistor mentioned in this publication may be configured as a MOSFET transistor, in particular as a N-channel MOSFET transistor or as a P-channel MOSFET transistor.

The first switching transistor 112 is integrated into the second circuit branch 122. In an example, the first switching transistor 112 is integrated into the second circuit branch 122 in such a way that the first switching transistor 112 may open or close the second circuit branch 122, in particular in an analog manner to a switch. For example, if the first switching transistor 112 is configured as a MOSFET transistor, the first switching transistor 112 may form a very high electrical resistance between a drain terminal and source terminal of the first switching transistor 112 in the open state. In the example mentioned above, the first switching transistor 112 may form a very small electrical resistance between the drain terminal and the source terminal in the closed state. The closed state of the first switching transistor 112, alternatively, may corresponds to MOSFET's active state (saturation mode), depending on conditions of utilized bias voltage on its gate terminal 194, load current I2 in the second branch and voltage drop between terminals 108 and 110, that the load current creates. In an example, the first switching transistor 112 may comprise a gate terminal 194 through which the first switching transistor 112 is controllable. Through the gate terminal 194, the first switching transistor 112 may be controlled, for example, to change to the open state or to the closed state.

The driver circuit 102 comprises a current mirror 114, also referred to as a first current mirror 114. The first current mirror 114 comprises a transistor 116, also referred to as a first reference transistor 116, and a further transistor 118, also referred to as a first mirror transistor 118. The first reference transistor 116 is integrated into the first circuit branch 120 of the driver circuit 102. The first mirror transistor 118 is integrated into the second circuit branch 122. As an effect, the first switching transistor 112 and the first mirror transistor 118 are integrated into the second circuit branch 122, in particular so that the first switching transistor 112 and the first mirror transistor 118 are connected in series. The gate terminal 184 of the first reference transistor 116 may be coupled to the gate terminal 124 of the first mirror transistor 118, in particular via the link 186. The link 186 may also be referred to as the gate connection link 186. The drain terminal of the first reference transistor 116 may be coupled to the gate terminal 184 of the first reference transistor 116 via a further link 182. The link 182 may also be referred to as the coupling link 182. In an example, the coupling link 182 may extend from a node 178 at a point of the first circuit branch 120 to the gate terminal 184 of the first reference transistor 116 or to the gate link 186. The node 178 may also be referred to as a third node 178.

In an example, a link may be generally understood as an electrical connection, in particular an electrical conductive line or path, for example in a chip and/or printed circuit board.

In Figure 1, a capacitor 180 is schematically shown, in particular by dashed lines. The capacitor 180 may represent an intrinsic capacitance between the drain terminal 123 of the first mirror transistor 118 and the gate terminal 124 of the first mirror transistor 118. The capacitance may also be referred to as the drain-gate capacitance of the first mirror transistor 118. The capacitor 180 schematically shown in Figure 1 may be integrally formed by the first mirror transistor 118. The intrinsic capacitance of the capacitor 180 may be due to the structure of the first mirror transistor 118. The capacitor 180 is not an additional component of the driver circuit 102. Due to the integral design of the capacitor 180 by the first mirror transistor 118, the capacitor 180 is shown in Figure 1 in dashed lines. In fact, the intrinsic capacitance of capacitor 180 is located in the first mirror transistor 118. Therefore, capacitor 180 may also be referred to as intrinsic capacitor 180.

In an example, the driver circuit 102 comprises a current source 136, also referred to as a first reference current source 136. The first reference current source 136 may be integrated in the first branch circuit 120. The first reference current source 136 may be configured to generate a predefined current, also referred to as a first branch current I1. The first branch current I1 may be a first reference current I1. The first branch current I1 may be a constant, predefined current.

The third node 178 may be arranged at a location of the first circuit branch 122 between the first reference transistor 116 and the first reference current source 136.

In an example, the first branch current I1 generated by the first reference current source 136 may flow through the first reference transistor 116. The first current mirror 114 may cause a second current I2, referred to as the second branch current I2, in the second circuit branch 122 through the first mirror transistor 118. The first current mirror 114 may be configured such that the second branch current I2 is in a predefined ratio to the first branch current I1. This predefined ratio preferably applies in a transient state and/or after a certain transition time.

The first current mirror 114 may act as a current source for the second circuit branch 122. The first switching transistor 112 may be used to control whether or not the second branch current I2 is actually generated at the second driver terminal 108. Whether the second branch current I2 actually flows may also depend on the load branch 164. If the load path 164 is coupled between the first driver terminal 106 and the second driver terminal 108, then in an example, the first switching transistor 112 may be used to control whether the second driver current I2 flows through the load branch 164 or not.

The driver system 100 may comprise a control unit 140. The control unit 140 may be coupled to the gate terminal 194 of the first switching transistor 112 via a control circuit 172. The control unit 140 may be configured to control the first switching transistor 112 via the control circuit 172 in such a way that the first switching transistor 112 is in a conductive state (also referred to as closed state), in particular with a low electrical resistance between the drain terminal and the source terminal. The conductive state of the first switching transistor 112 may also be referred to as a closed state of the first switching transistor 112. The control unit 140 may be configured to control the first switching transistor 112 via the control circuit 172 in such a way that the first switching transistor 112 is in the non-conducting state (also referred to as open state), in particular with a very high electrical resistance between the drain terminal and the source terminal. The non-conducting state of the first switching transistor 112 may also be referred to as the open state of the first switching transistor 112.

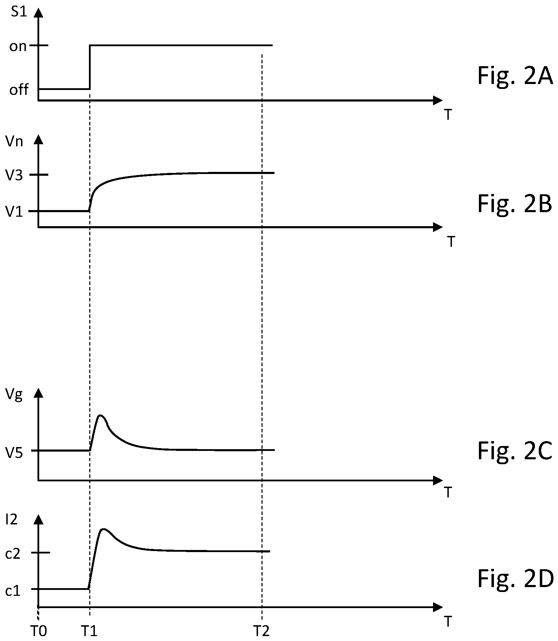

A state diagram for the first switching transistor 112 is schematically shown in Figure 2A. At time T0, the first switching transistor 112 is in open state ("off'). At time T1, the first switching transistor 112 changes from the open state to the closed state ("on"). The control unit 140 may be configured to control the first switching transistor 112 via the control circuit 172 and the gate terminal 194 such that the first switching transistor 112 changes from the open state to the closed state at time T1. In the time between time T1 and time T2, the first switching transistor 112 is in the closed state.

Figure 2B is a schematic diagram illustrating an example of an electrical voltage Vn at a location 154 of the second circuit branch 122, wherein the location 154 is also referred to as a node 154 or a first node 154. The voltage Vn is also referred to as a first node voltage Vn. The first node 154 is arranged between the first switching transistor 112 and the first mirror transistor 118. The source terminal of the first mirror transistor 118 may be coupled to the third driver terminal 110. The drain terminal of the first switching transistor 112 may be coupled to the second driver terminal 108. The source terminal of the first switching transistor 112 may be coupled to the drain terminal 123 of the first mirror transistor 118.

Figure 2C is a diagram, which schematically illustrates an example of an electrical voltage Vg at the gate terminal 124 of the first mirror transistor 118 and/or the gate link 186. The voltage Vg is also referred to as the first gate voltage Vg.

Figure 2D is a diagram, which schematically illustrates an example of the second branch current I2.

At time T0, the first switching transistor 112 is in the open state. As an effect, the second branch current I2 is zero or comprises an (in particular small) initial value c1. As a further effect, the first node voltage Vn at the first node 154 may have an (in particular small) initial value V1. At time T0, the first branch current I1 caused by the first reference current source 136 may flow in the first circuit branch I1. Due to the first branch current I1, a voltage may drop across the gate-source terminals of the first reference transistor 116, which at time T0 may define the voltage value of the first gate voltage Vg. As an effect, the first gate voltage Vg may have an initial value V5 at time T0.

The above explanations, optional features, technical effects and/or advantages as described for the driver system 100 may apply in an analogous manner for the further example of the driver system 100 as schematically illustrated in Figure 3. However, only the explanations in the following paragraph do not apply to driver system 100 of Figure 3, in particular when reference is made to any of Figures 3-6.

As may be seen in Figure 2A, at time T1, the first switching transistor 112 may be controlled by the control unit 140 such that the first switching transistor 112 changes from the open state to the closed state. As result of state change of the first switching transistor 112, the first node voltage Vn rapidly increases, as may be seen on Figure 2B. Due to capacitor 180 or the associated drain gate capacitance of the first mirror transistor 118, the rapidly rising first node voltage Vn causes a charge injection and corresponding temporal increase in the first gate voltage Vg, as may be seen on Figure 2C. In the example of the driver system 100 from Figure 1, an effect of temporal increase of the first gate voltage Vg may be observed as overshoot of branch current I2, which may also be seen in Figure 2D. After the overshoot, the first gate voltage Vg will decay to its stationary value with respect to time constant of the first current mirror 114. As an effect, in the example of the driver system according to Figure 1, an overshoot and slow settling behavior of the second branch current I2 occurs before the second branch current reaches a target value c2. The associated voltage waveform of the first node voltage Vn is shown schematically in Figure 2B.

Driver systems 100, used for example as drivers for a load branch 164, may be subject to face certain challenges. For example, a fast switching capability may be of advantage for a driver system 100. In particular, it may also be of advantage for the driver system 100 if the driver system 100 could drive the load branch 164 with a small rise time and/or with a small fall time. Furthermore, it may be of advantage for the driver system 100 if an overshoot behavior of a current through the load branch 164 could be avoided or limited to a small extent. In an example, it would be of further advantage, if the driver system 100 could provide low overshoot and fast settling behavior after turning on the current to drive the load branch 164, in particular while allowing a quick rise time in the current waveform of the current in the load branch 164.

Figure 3 schematically shows a further example of a driver system 100. The above explanations, optional features, technical effects and/or advantages apply as discussed in connection with the driver system 100 of Figure 1 may apply in an analogous manner to the driver system 100 in Figure 3, with the exception of the penultimate paragraph. The penultimate paragraph is an exception in that the penultimate paragraph explains an effect on overshoot and slow settling behavior that may be overcome with the driver system 100 of Figure 3. At the same time, the driver system 100 of Figure 3 may offer the possibility of rapidly increasing and settling the current through the load branch 164 and/or the second branch current I2.

The driver system 100, schematically shown for example in Figure 3, comprises the driver circuit 102 and a circuit 104. The circuit 104 may also be referred to as a compensation circuit 104. The driver system 100 comprises the first driver terminal 106, the second driver terminal 108 and the third driver terminal 110. In an example, the driver terminals 106, 108, 110 may be formed by the driver circuit 102.

The compensation circuit 104 is coupled to the gate terminal 124 of the first mirror transistor 118. The compensation circuit 104 comprises a branch 126, which is also referred to as compensation branch 126. The compensation branch 126 is coupled between the gate terminal 124 of the first mirror transistor 118 and the third driver terminal 110. The compensation circuit 104 comprises a second switching transistor 128 and a capacitor 130. The capacitor 130 may also be referred to as a compensation capacitor 130. The second switching transistor 128 and the compensation capacitor 130 are integrated into the compensation branch 126. In Figure 3, the second switching transistor 128 is schematically symbolized by a switch.

In an example, the driver circuit 102 comprises a link 190, also referred to as a second rail link 190. The second rail link 190 is coupled to the third driver terminal 110. In an example, the compensation branch 126 may extend from the third node 178 to the second link 190. The third node 178 may be coupled to the gate terminal 124 of the first mirror transistor 118 via the coupling link 182 and the gate link 186. As an effect, the compensation branch 126 may be coupled to the gate terminal 124 of the first mirror transistor 118 via the third node 178, the coupling link 182, and the gate link 186.

The driver system 100 may further comprise the control unit 140 and/or the control circuit 172. In an example, the control unit 140 may be coupled to the control circuit 172 via a second control link 176. In an example, the control circuit 172 may be coupled to the gate terminal 194 of the first switching transistor 112 via the third control link 196. The control unit 140 may be coupled to the first switching transistor 112 via the second control link 176, the control circuit 172, and the third control link 196 for controlling the first switching transistor 112. The control unit 140 may be configured to control the switching transistor 112 into the open state or into the closed state. In an example, the control unit 140 may be coupled to the compensation circuit 104 via the first control link 174. Furthermore, the control unit 140 may be coupled to the second switching transistor 128, in particular to a gate terminal of the second switching transistor 128, via the compensation circuit 104, in order to control the second switching transistor 128 into a closed state or into an open state.

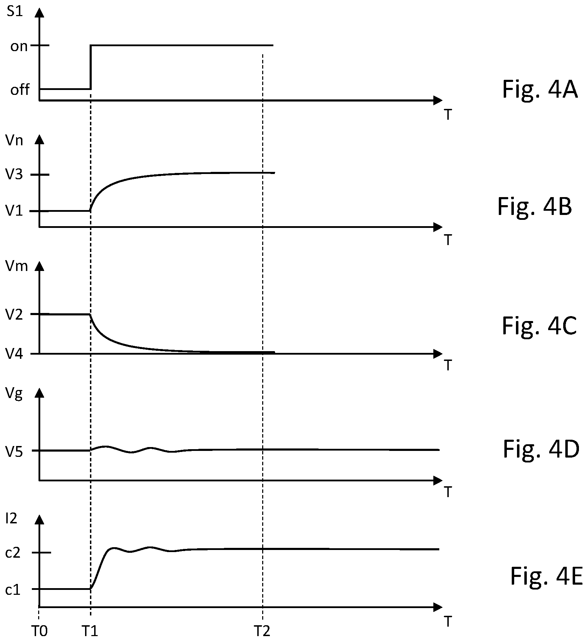

Figures 4A to 4E schematically illustrates different diagrams in connection with the example of the driver system 100 of Figure 3.

Figure 4A schematically shows a state diagram for the first switching transistor 112. At time T0, the first switching transistor 112 is in an open state ("off"). At time T1, the first switching transistor 112 changes from the open state to the closed state ("on"). The control unit 140 may be configured to control the first switching transistor 112 via the control circuit 172 and the gate terminal 194 such that the first switching transistor 112 changes from the open state to the closed state at time T1. In the time between the time T1 and the time T2, the first switching transistor 112 is in the closed state.

It was explained previously that the state diagram of Figure 4A schematically represents a state diagram for the first switching transistor 112. However, the state diagram of Figure 4A may also or alternatively schematically represent a state diagram for the second switching transistor 128. As a result, Figure 4A may, in an example, schematically show a state diagram for both the first switching transistor 112 and the second switching transistor 128. At time T0, the second switching transistor 128 is in an open state ("off"). At time T1, the second switching transistor 128 changes from the open state to the closed state ("on"). The control unit 140 may be configured to control the second switching transistor 128 via the control link 174 and the gate terminal of the second switching transistor 128 in such a way that the second switching transistor 128 changes from the open state to the closed state at time T1. During the time between the time T1 and the time T2, the second switching transistor 128 is in the closed state. The time T1 may also be referred to as the turn-on time T1. As an effect, the driver system 100 may be configured to control the first and second switching transistors 112, 128 to the closed state at the turn-on time T1, in particular simultaneously.

Figure 4B schematically shows a diagram that represents an example of an electrical voltage Vn at the first node 154. The voltage Vn is also referred to as the first node voltage Vn.

The compensation branch 126 may be comprised between the compensation capacitor 130 and the second switching transistor 128 at a location also referred to as the second node 156. In Figure 4C, a diagram is schematically shown that represents an example of an electrical voltage Vm at the second node 156. The voltage Vm is also referred to as the second node voltage Vm.

In Figure 4D, a diagram is schematically shown that represents an example of the first gate voltage Vg at the gate terminal 124 of the first mirror transistor 118 and/or at the gate connection link 186.

In Figure 4E, a schematic diagram is shown that represents an example of the second branch current I2 in the second circuit branch 122.

At time T0, the first switching transistor 112 and the second switching transistor 128 are in the open state. As an effect, the second branch current I2 is zero or comprises an (in particular small) initial value c1. As a further effect, the first node voltage Vn at the first node 154 may have an (in particular small) initial value V1. At time T0, the first branch current I1 caused by the first reference current source 136 may flow in the first circuit branch I1. Due to the first branch current I1, a voltage may drop across the gate-source terminals of the first reference transistor 116, which at time T0 may define the voltage value of the first gate voltage Vg. As an effect, the first gate voltage Vg at time T0 may have an initial value V5. In addition, the second node voltage Vn at time T0 may have a predefined value. In an example, the compensation capacitor 130 may be pre-charged at time T0 such that the second node voltage Vn at time T0 is greater than the first gate voltage I1 at time T0.

As may be seen in Figure 4A, at time T1, the first switching transistor 112 may be controlled by the control unit 140 such that the first switching transistor 112 changes from the open state to the closed state.

Figure 2C shows that the first gate voltage Vg (without the compensation circuit 104) would comprise a wave-shaped voltage disturbance after time T1. Without the compensation circuit 104, the disturbance in the form of the voltage wave of the first gate voltage Vg would cause the overshoot and slow settling behavior of the second branch current I2 (also following the time T1). Both the voltage disturbance of the first gate voltage Vg and the overshoot behavior of the second branch current I2 may be avoided or significantly reduced with the compensation circuit 104.

It was explained previously that Figure 4A may also represent a state diagram of the second switching transistor 128. In an example, at time T1, the control unit 140 may control the second switching transistor 128 to change it from the open state to the closed state.

After the closing of the first switching transistor 112 at time T1 the first node voltage Vn may increase from an initial value V1 to a target value V3 in the time period between times T1 and T2, as shown schematically in Figure 4B. The initial value V1 may also be referred to as a first reference value V1. The first reference value V1 may be predefined. The target value V3 may also be referred to as a third reference value V3. The third reference value V3 may be predefined. As a result, the driver system 100 in an example may be configured to generate a first node voltage Vn, increasing to the first reference value V3, at a first node 154 of the second circuit branch 122 in response to if the first switching transistor 112 changes to the closed state, wherein the first node 154 is arranged in the second circuit branch 122 between the first switching transistor 112 and the first mirror transistor 118. As a further result, the driver system 100 may be configured in an example such that, in response to the first switching transistor 112 changing to the closed state, the first node voltage Vn increases from the third reference value V1 to the first reference value V3.

By closing the second switching transistor 128 at time T1, the compensation capacitor 130 is coupled between the gate terminal 124 of the first mirror transistor 118 and the third driver terminal 110. Figure 4C schematically illustrates an example of a voltage transition of the second node voltage Vm. As may be seen from Figure 4C, the second node voltage Vm decreases from an initial value V2 of the second node voltage Vm to a target value V4 of the second node voltage Vm from the time T1 onward. The initial value V2 may also be referred to as a second reference value V2. The second reference value V2 may be predefined. The target value V4 may also be referred to as the fourth reference value V4. The fourth reference value V4 may be predefined. In an example, the voltage waveform of the second node voltage Vm between T1 and T2 may be complementary to the voltage waveform of the first node voltage Vn between T1 and T2.

The driver system 100 may be configured to control the first and second switching transistors 112, 128 to the closed state at the turn-on time T1, in particular simultaneously. As an effect, charge injected by transition of the second node voltage Vm through the compensation capacitance 130 may compensate or greatly reduce charge injected by transition of the first node voltage Vn through the capacitance 180 on the first gate voltage Vg. As a result, voltage of the first gate voltage Vg is not disturbed as much as for the driver system 100 of Figure 1, that allows the second branch current I2 to increase and to settle to its final value rapidly thereafter, which is schematically shown in Figure 4E. From time T1, the second branch current I2 may increase from an initial value c1 to the target value c2 in the period between time T1 and time T2.

The driver system 100 in an example may be configured to generate the second node voltage Vm dropping from the second reference value V2 at the second node 156 of the compensation branch 126 in response to the event if the second switching transistor 128 changes to the closed state, wherein the second node 156 is arranged in the compensation branch 126 between the second switching transistor 128 and the compensation capacitor 130. As a further result, in an example, the driver system 100 may be configured such that the second node voltage Vm drops from the second reference value V2 to the fourth reference value V4, in response, if the second switching transistor 128 changes to the closed state.

Particularly good compensation or reduction of the overshoot and settling time may be achieved if the signal waveform of the first node voltage Vn and the signal waveform of the second node voltage Vn are complementary or mirror-symmetrical.

In an example, the compensation capacitance of compensation capacitor 130 corresponds to the drain-gate capacitance 180 of the first mirror transistor 118. As an effect, the waveform of the first node voltage Vn and the waveform of the second node voltage Vm may be complementary or mirror-symmetrical, in particular after T1 and/or during the time between T1 and T2. As a further effect, charge, that is induced by the change of the first node voltage Vn and reaches the gate connection link 186 via the drain-gate capacitance (capacitor 180) of the first mirror transistor 118, may be subtracted by charge, that is induced by the opposite polarity change of the second node voltage Vm and reached gate connection link 186 vias compensation capacitor 130, so that no or only very slight disturbances affect the first gate voltage Vg. No or only very slight disturbances of the first gate voltage Vg may allow to avoid over-shoot (or undershoot by overcompensation) and to establish rapid settling of the second branch current I2 to its stationary value c2.

In an example, the voltage waveform of the first gate voltage Vg after time T1 (see Figure 4D) may have a very slight or negligible settling behavior, shown as example of possible mismatches in shapes of voltage change on nodes Vn and Vm. Generally transitions of nodes Vn and Vm may take less time comparing with settling recovering after an overshoot or undershoot. In such circumstances, a matching in charges, given by magnitudes of Vn and Vm transitions, matters, rather than a matching symmetry of their waveforms. As an effect, the compensation circuit 104 may prevent or reduce the disturbance of the first gate voltage Vg. Furthermore, the cooperation of the driver circuit 102 and the compensation circuit 104 may allow that the second branch current I2 settle rapidly and without overshoot after time T1.

It was explained previously that it might be of advantage if the second branch current I2 reaches a target value c2 at time T2. The target value c2 of the second branch current I2 may be in a predefined relationship to the value of the first branch current I1. The relationship may be defined by the current mirror 114. In an example, the first reference transistor 116 is coupled to the first current mirror 118 so as to control the first current mirror 118 such that the second branch current I2 through the second circuit branch 122 is caused based on the first branch current I1 through the first circuit branch 120. In an example, the driver circuit 102 comprises the first reference current source 136, which may be integrated into the first circuit branch 120. The first reference current source 136 may be configured to generate the first branch current I1. As an effect, the first branch current I1 may be generated precisely. Via the first current mirror 114, the ratio between the first branch current I1 and the second branch current I2 may be set, in particular at least for the target value c2 of the second branch current I2.

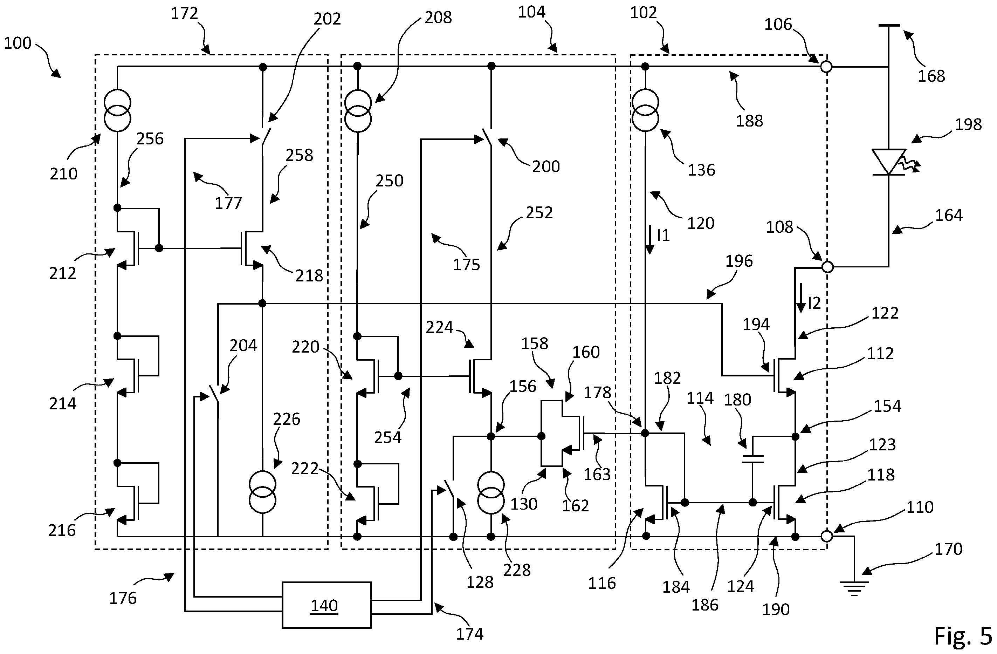

A further example of the driver system 100 is shown schematically in Figure 5. Reference is made, by way of analogy, to the foregoing explanations, optional features, effects and advantages as explained in connection with Figures 3 and 4A to 4E.

The compensation circuit 104 may comprise a third circuit branch 250 and a fourth circuit branch 252. The third circuit branch 250 may be coupled between the first driver terminal 106 and the third driver terminal 110. In an example, the driver circuit 102 comprises a link 188, also referred to as a first link rail 188. In addition, the driver circuit 102 may comprise a further link 190, also referred to as a second link rail 190. In an example, the third branch circuit 250 is coupled between the first link rail 188 and the second link rail 190. The fourth circuit branch 252 may be coupled between the first driver terminal 106 and the third driver terminal 110. In an example, the fourth circuit branch 252 may be coupled between the first link rail 188 and the second link rail 190.

The third circuit branch 250 may include a second current source 208, which may also be referred to as a second reference current source 208. In addition, the third circuit branch 250 may include two transistors 220, 222. The transistor 220 may be referred to as a second reference transistor 220. Transistor 222 may be referred to as the first base transistor 222. The second reference current source 208, the second reference transistor 220, and the first base transistor 222 may be integrated in series, in particular in the order mentioned, into the third circuit branch 250.

A switch 200 may be integrated into the fourth circuit branch 252. The switch 200 may be formed by a transistor. Furthermore, a further transistor 224 may be integrated into the fourth circuit branch 252. The transistor 224 may also be referred to as a second mirror transistor 224. Furthermore, a further current source 228 may be integrated into the fourth circuit branch 252. The current source 228 may be referred to as a third reference current source 228. The switch 200, the second mirror transistor 224, and the third reference current source 228 may be integrated into the fourth circuit branch 252 in series, in particular in the order mentioned.

The drain terminal of the second reference transistor 220 and the gate terminal of the second reference transistor 220 may be coupled. The gate terminal of the second reference transistor 220 may be coupled to the gate terminal of the second mirror transistor 224. As an effect, the second reference transistor 220 and the second mirror transistor 224 may form a second current mirror 254.

The switch 128 may be formed by the second switching transistor 128. The second switch 128, in particular the second switching transistor 128, may be coupled in parallel with the third reference current source 228. In an example, the switch 128, in particular the second switching transistor 128, may be coupled between the second rail link 190 and the second node 156. The second node 156 may be arranged at a location of the fourth circuit branch 252 between the second mirror transistor 224 and the third reference current source 228.

The control unit 140 may be coupled to the switch 128, in particular to the gate terminal of the second switching transistor 128, via the control link 174 to control the switch 128 or the second switching transistor 128, respectfully. The control unit 140 may be coupled to the switch 200 via a further control link 175 to control the switch 200.

The compensation capacitor 130 may be coupled between the second node 156 and the third node 178. In an example, the compensation capacitor 130 is formed by a transistor 158, also referred to as a compensation transistor 158. The compensation transistor 158 has a drain terminal 160 coupled to a source terminal 162 of the compensation transistor 158. In this example, both the drain terminal 160 and the source terminal 162 are coupled to the third node 156. A gate terminal 163 of the compensation transistor 158 is coupled to the second node 178.

The compensation capacitance formed by the compensation transistor 158 may equal the drain-gate capacitance 180 of the first mirror transistor 118. As a further effect, the signal waveforms of the first node voltage Vn and the second node voltage Vm may be complementary, so that no or only a very small interference behavior occurs at the first gate voltage Vg. In an example of equivalent gate-drain and gate-source capacitances, that is valid for symmetrical MOSFETs, a channel width of the compensation transistor 158 may be a half of a channel width of the first mirror transistor 118.

An example of the control circuit 172 is shown in Figure 5. The control circuit 172 may include a fifth circuit branch 256 and a sixth circuit branch 258. The fifth circuit branch 256 may be coupled between the first driver terminal 106 and the third driver terminal 110. In an example, the fifth circuit branch 256 is coupled between the first link rail 188 and the second link rail 190. The sixth circuit branch 258 may be coupled between the first driver terminal 106 and the third driver terminal 110. In an example, the sixth branch circuit 258 may be coupled between the first link rail 188 and the second link rail 190.

A current source 210 may be integrated into the fifth branch circuit 258. The current source 210 may also be referred to as a fourth reference current source 210. Furthermore, three transistors 212, 214, 216 may be integrated into the fifth circuit branch 256. Transistor 212 may be referred to as the third reference transistor 212. Transistors 214, 216 may be referred to as second base transistor 214 and third base transistor 216. The fourth reference current source 210, the third reference transistor 212, the second base transistor 214, and the third base transistor 216 may be integrated in series, in particular in the order mentioned, into the fifth circuit branch 256.

A switch 202 may be integrated into the sixth circuit branch 258. The switch 202 may be formed by a transistor. Furthermore, a further transistor 218 may be integrated into the sixth circuit branch 258. The transistor 218 may also be referred to as the third mirror transistor 118. Furthermore, a further current source 226 may be integrated into the sixth circuit branch 258. The current source 226 may be referred to as the fifth reference current source 228. The switch 208, the third mirror transistor 218, and the fifth reference current source 226 may be integrated in series, in particular in the order mentioned, into the sixth circuit branch 258.

The control circuit 172 may comprise a further switch 204 coupled in parallel with the fifth reference current source 226. The control unit 140 may be coupled to the switch 204 via the control link 177 to control the switch 204. The control unit 140 may be coupled to the switch 202 via the control link 176 to control the switch 202.

The control unit 140 may be configured to control the control circuit 172 at time T0 in such a way that the second branch current I2 comprises a value of zero or a predefined (in particular small) initial value c1. For this purpose, the control unit 140 may control the switch 204 such that the switch 204 is in a closed state and control the switch 202 such that the switch 202 is in an open state.

The control unit 140 may be configured to control the compensation circuit 104 at time T0 such that the compensation circuit 104 performs a compensation of disturbances resulting from charge injection through the drain-source capacitance of the first mirror transistor 118.

The control unit 140 may be configured to control the switch 128, in particular the compensation transistor 128, at the time T0 such that the switch 128 or the compensation transistor 128, respectfully, is in an open state. The control unit 140 may be configured to control the switch 200 at the time T0 so that the switch 200 is in a closed state.

The control unit 140 may be configured to continue the control explained above from time T0 to time T1. As an effect, the compensation transistor (capacitor) 130 may be charged during the period between time T0 and time T1, in particular to a predefined charge level, which might be higher than zero.

The control unit 140 may be configured to control the switch 204 at the time T1 so that the switch 204 changes to the open state and to control the switch 202 so that the switch 202 changes to the closed state. As an effect, the gate terminal 194 of the first switching transistor 112 is controlled via the link 196 such that the first switching transistor 112 changes to the closed state. The closing of the first switching transistor 112 causes an increase in the second branch current I2, in particular such that the second branch current I2 increases to the target value c2.

The control unit 140 may be configured to control the compensation circuit 104 at time T1 such that the switch 200 changes to the open state and to control the switch 128 or the compensation transistor 128 such that the switch 128, in particular the compensation transistor 128 changes to the closed state. As an effect, the second node voltage Vm decreases.

In an example, gate terminal 194 of the switching transistor 112 may is driven by control circuit 172 and controlled by the control unit 140. In the closed state of the switching circuits 112, 128, the bias conditions may match between switching transistor 112 and the base transistor 214. As an effect, the amplitude of a voltage transition of the first node voltage Vn may be limited to a voltage set by drop across the base transistor 216. In an example, when bias condition of the base transistor 216 is close to bias condition of the first reference transistor 116 it may also have a positive effect on accuracy of the first current mirror 114 in presence of channel modulation effect.

In an example, a voltage transition of the second node voltage Vm may be complementary to a voltage transition of the first node voltage Vn. The base transistors 216, 222 may be configured with equally or similar, or may be given as voltage sources represented by other circuitries. As an effect, both voltage transitions for the first and second node voltages Vn, Vm may match by their amplitudes or scaled reciprocally to the scale between compensation capacitor 130 and gate-drain capacitance 180.

In Figures 3 and 5, the load branch 164 is coupled between the first driver terminal 106 and the second driver terminal 108. Alternatively, the load branch 164 may be coupled between the second driver terminal 108 and the third driver terminal 110.

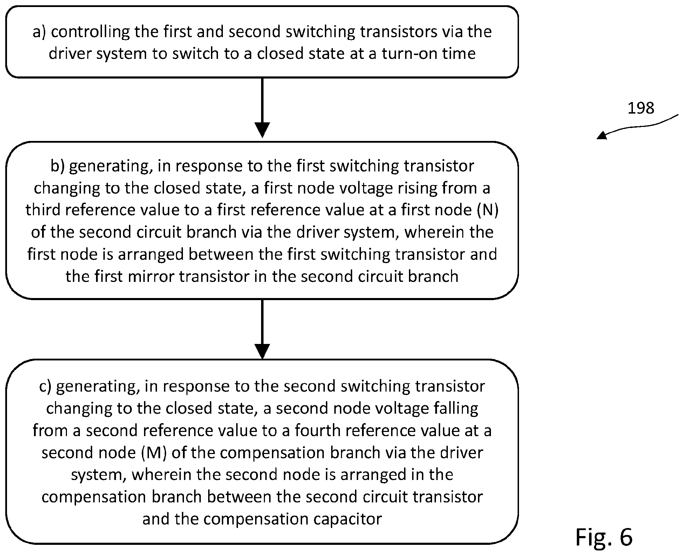

Figure 6 schematically illustrates an example of a method 166 for the driver system 100. The method my be used to operate the driver system 100. The method 166 may comprise the following steps: a) controlling the first and second switching transistors via the driver system to switch to a closed state at a turn-on time; b) generating, in response to the first switching transistor changing to the closed state, a first node voltage rising from a third reference value to a first reference value at a first node (N) of the second circuit branch via the driver system, wherein the first node is arranged between the first switching transistor and the first mirror transistor in the second circuit branch; and c) generating, in response to the second switching transistor changing to the closed state, a second node voltage falling from a second reference value to a fourth reference value at a second node (M) of the compensation branch via the driver system, wherein the second node is arranged in the compensation branch between the second circuit transistor and the compensation capacitor.

The above explanations, optional features, technical effects and/or advantages as described for the driver system 100 may apply in an analogous manner for the method 166.

Although the described exemplary embodiments disclosed herein focus on devices, systems, and methods for using same, the present disclosure is not necessarily limited to the example embodiments illustrate herein.

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

## Claims

1. A driver system, the driver system comprising:
a driver circuit, a compensation circuit, a first driver terminal, a second driver terminal, and a third driver terminal,
wherein the driver circuit comprises a first switching transistor and a first current mirror,
wherein the first current mirror comprises a first reference transistor and a first mirror transistor,
wherein the first reference transistor is integrated into a first circuit branch of the driver circuit, wherein the first circuit branch extends from the first driver terminal to the third driver terminal,
wherein the first switching transistor and the first mirror transistor are integrated into a second circuit branch of the driver circuit, such that the first switching transistor and the first mirror transistor are connected in series, wherein the second circuit branch extends from the second driver terminal to the third driver terminal,
wherein the compensation circuit is coupled to the gate terminal of the first mirror transistor,
wherein the compensation circuit comprises a compensation branch coupled between the gate terminal of the first mirror transistor and the third driver terminal of the driver circuit, and
wherein a second switching transistor and a compensation capacitor are integrated in the compensation branch.

2. The driver system according to the preceding claim, wherein the first reference transistor is coupled to the first mirror transistor to control the first mirror transistor such that a second branch current through the second circuit branch is caused based on a first branch current through the first circuit branch.

3. The driver system according to the preceding claim, wherein a first current source is integrated into the first circuit branch, which is configured to generate the first branch current, in particular as a predefined first branch current.

4. The driver system according to any of the preceding claims, wherein the compensation circuit is configured to precharge the compensation capacitor.

5. The driver system according to any of the preceding claims, wherein the driver system is configured to drive the first and second switching transistors to a closed state at a turn-on time.

6. The driver system according to the preceding claim, wherein the driver system comprises a control unit configured to drive the first and second switching transistors to the closed state at the turn-on time.

7. The driver system according to any of the preceding claims 5 to 6, wherein the driver system is configured to generate a first node voltage, which rises to a first reference value, at a first node (N) of the second circuit branch in response to the first switching transistor changing to the closed state, wherein the first node is arranged in the second circuit branch between the first circuit transistor and the first mirror transistor.

8. The driver system according to the preceding claim, wherein the driver system is configured to generate a second node voltage, falling from a second reference value, at a second node (M) of the compensation branch in response to the second switching transistor changing to the closed state, wherein the second node is arranged in the compensation branch between the second circuit transistor and the compensation capacitor.

9. The driver system according to any of the preceding claims 5 to 8, wherein the driver system is configured, in response to the second switching transistor changing to the closed state, such that the second node voltage falls from the second reference value to a fourth reference value.

10. The driver system according to any of the preceding claims 5 to 9, wherein the driver system is configured, in response to the first switching transistor changing to the closed state, such that the first node voltage rises from a third reference value to the first reference value.

11. The driver system according to any of the preceding claims, wherein the compensation capacitance of the compensation capacitor corresponds to a drain-gate capacitance of the first mirror transistor.

12. The driver system according to the preceding claim, wherein the compensation capacitor is formed by a compensation transistor which drain terminal and source terminal are coupled.

13. The driver system according to the preceding claim, wherein a channel width of the compensation transistor corresponds to half of a channel width of the first mirror transistor.

14. The driver system according to any of the preceding claims, wherein a load branch is coupled either between the first driver terminal and the second driver terminal or between the second driver terminal and the third driver terminal.

15. A method for a driver system, the driver system comprising a driver circuit, a compensation circuit, a first driver terminal, a second driver terminal, and a third driver terminal, wherein the driver circuit comprises a first switching transistor and a first current mirror, wherein the first current mirror comprises a first reference transistor and a first mirror transistor, wherein the first reference transistor is integrated into a first circuit branch of the driver circuit, wherein the first circuit branch extends from the first driver terminal to the third driver terminal, wherein the first switching transistor and the first mirror transistor are integrated into a second circuit branch of the driver circuit, such that the first switching transistor and the first mirror transistor are connected in series, wherein the second circuit branch extends from the second driver terminal to the third driver terminal, wherein the compensation circuit is coupled to the gate terminal of the first mirror transistor, wherein the compensation circuit comprises a compensation branch coupled between the gate terminal of the first mirror transistor and the third driver terminal of the driver circuit, wherein a second switching transistor and a compensation capacitor are integrated in the compensation branch, and the method comprising the steps of:
a) controlling the first and second switching transistors via the driver system to switch to a closed state at a turn-on time;
b) generating, in response to the first switching transistor changing to the closed state, a first node voltage rising from a third reference value to a first reference value at a first node (N) of the second circuit branch via the driver system, wherein the first node is arranged between the first switching transistor and the first mirror transistor in the second circuit branch; and
c) generating, in response to the second switching transistor changing to the closed state, a second node voltage falling from a second reference value to a fourth reference value at a second node (M) of the compensation branch via the driver system, wherein the second node is arranged in the compensation branch between the second circuit transistor and the compensation capacitor.
